Europäisches Patentamt

European Patent Office

Office européen des brevets

(19)

(11) EP 0 536 660 B1

(12) **EUROPEAN PATENT SPECIFICATION**

(45) Date of publication and mention
of the grant of the patent:
**03.04.1996 Bulletin 1996/14**

(51) Int Cl.6: **H03L 7/081**, H03C 3/06

(21) Application number: 92116928.0

(22) Date of filing: **02.10.1992**

(54) **Process for broadening the frequency response band of a voltage-controlled crystal oscillator and associated circuit**

Verfahren zur Erweiterung der Durchlassfrequenzbandbreite eines spannungsgesteuerten Kristalloszillators und mitverbundene Schaltung

Procédé pour étendre la largeur de bande de la réponse d'un oscillateur à cristal commandé en tension et circuit associé

(84) Designated Contracting States:
**DE ES FR GB GR IT SE**

(30) Priority: **08.10.1991 IT MI912669**

(43) Date of publication of application:
**14.04.1993 Bulletin 1993/15**

(73) Proprietor: **SIEMENS TELECOMUNICAZIONI S.P.A.**
**I-20060 Cassina de Pecchi (Milano) (IT)**

(72) Inventors:
- **Casanova, Mauro**
  **I-20060 Cassina De' Pecchi (MI) (IT)**
- **Ferrucci, Luca**
  **I-20145 Milano (IT)**

(56) References cited:
**US-A- 2 770 730**     **US-A- 4 009 450**
**US-A- 4 023 115**

EP 0 536 660 B1

## Description

The present invention relates to the field of synchronization of digital signals and more precisely addresses a process for broadening the frequency response band of a voltage-controlled crystal oscillator and the circuit originating therein.

It is known that in the reception of digital signals transmitted on a physical carrier, the problem arises of reading the input data using a locally generated clock signal.

One solution often adopted in digital signal reception equipment is to read the input data by means of a local clock signal phase-locked to the transition-levels of the input data. This allows correct reading of the input data and at the same time great reliability of the clock signal used in the equipment. Generation and locking of the local clock signal are usually obtained by using a phase-locked loop (PPL).

The PLL theory has been amply developed and published in various articles and volumes. As a reference there can be mentioned for example the volume entitled "Phaselock Techniques" by F. M. Gardner published by John Wiley & Sons, second edition, year 1979; or the volume "Phase-locked Loops" by R. E. Best published by McGraw-Hill, year 1984, chapter three. Another example is described in US-A-4 023 115.

As known, a PLL is based on a voltage-controlled oscillator (VCO) whose output is the desired local clock signal.

The VCO is an oscillator equipped with a control input to which is applied a voltage which controls the oscillation frequency variations. Said variations are proportional to the control voltage in an entire range of frequencies centred around the nominal frequency of the VCO.

In some specific segments of the application field of the invention such as for example that of synchronization of digital signals transmitted on optical fibre, it becomes necessary to have a clock signal with an extremely stable frequency. The purpose is usually met by using a voltage-controlled crystal oscillator (VCXO) to generate the desired clock signal; in fact the quartz crystal has a resonance frequency which is very stable in temperature and little subject to variation due to ageing.

The VCXO theory has been known for a long time and an example of a very explanatory VCXO design is given in the article entitled "Linearization of Direct FM Frequency Modulators" by S. J. Lipoff published in IEEE Transactions on Vehicular Technology, vol.vt-27, N.l February 1978, pages 7-17.

One parameter which characterizes the VCXO is its frequency response band width to a sinusoidal control signal. More precisely, it is defined by means of the following expression:

$$\bar{K}_{vcxo}(j\omega_c) = \Delta \vec{f}_x(j\omega_x)/\vec{V}_i(j\omega_c)$$

where $\Delta \vec{f}_x$ is a vectorial expression which shows how the frequency of the oscillation generated by the VCXO varies around the nominal frequency $f_x = \omega_x/2\pi$ with the variation of the sinusoidal voltage $V_i$ applied at the control input, being $f_c = \omega_c/2\pi$ the frequency of the control signal Vi.

In analyzing the vector $\vec{K}_{vcxo}(j\omega_c)$ it is noted that module and phase remain constant as long as the frequency of the control signal is lower than a critical value $f_{cr}$, which is dependent on the physical and geometrical characteristics of the quartz used and the particular configuration of the oscillator circuit. For frequencies greater than $f_{cr}$, the module and phase values of the transfer function no longer remain constant.

It follows from the above remarks that it is permissible to define the frequency response band of a VCXO as the -3 dB band width of $|\vec{K}_{vcxo}(j\omega_c)|$, the condition verified for $|\vec{K}_{vcxo}(j\omega_{cr})|$, where $\omega_{cr} = 2\pi f_{cr}$.

The VCXO unfortunately have a very limited frequency response band, typically on the order of a few kHz. Therefore they are practically unusable in PLL structures when the frequency response band required at the PLL must be broad. This requirement also appears in the case of signals transiting on optical fibre; in fact the clock signal to which the PLL must lock is affected by fast phase jitter.

Accordingly the purpose of the present invention, as it is defined in the appended claims, is primarily to obviate said shortcoming and indicate a process to broaden the frequency response band of a voltage-controlled crystal oscillator.

To achieve said purposes the present invention has for its object a process to broaden the frequency response band of a voltage-controlled crystal oscillator (VXCO), consisting primarily of using directly the signal generated by the VCXO, as long as the frequency response of the latter remains constant, otherwise postmodulating the phase of the signal generated by the VCXO with the same signal which controls the VCXO, extending the amplitude of the frequency response field, as better described in claim 1.

Another object of the present invention is a circuit which embodies the above process as described in claim 3.

A VCXO of which the frequency response band has been broadened by the process which is the object of the present invention, can be used in a PLL having a frequency response band sufficiently broad to phase lock a clock signal which presents a fast phase jitter.

Other purposes and advantages of the present invention will be clarified by the detailed description below of an example of embodiment thereof and the annexed drawings given purely by way of nonlimiting example wherein: -

FIG. 1 shows a completely general block diagram of a circuit comprising a VCXO with phase postmodulator,

FIG. 2 shows the block diagram of a circuit comprising a VCXO with phase postmodulator in accordance with the present invention, and

FIG. 3 shows the circuit diagram derived from the block diagram of FIG. 2.

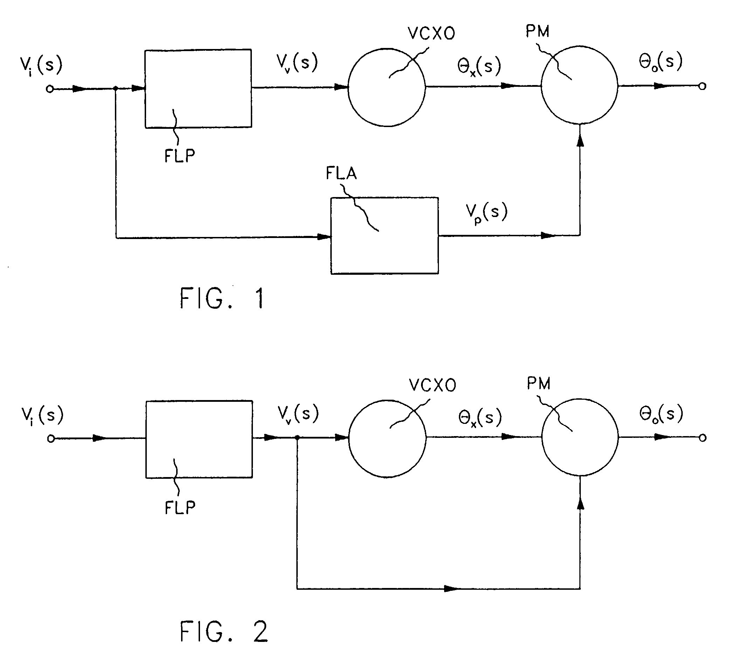

With reference to FIG. 1, FLP indicates a low-pass filter at whose input there is a signal $V_i(s)$ and at whose output there is a filtered signal $V_v(s)$ which reaches the control input of a block VCXO which represents a voltage controlled crystal oscillator. The oscillation output from VCXO reaches a signal input of a phase modulator PM even though, for ease of discussion, a signal $\Theta_x(s)$ representing only the oscillation phase at the output of VCXO is shown reaching said input.

The signal $V_i(s)$ also reaches the input of a filtering network FLA at whose output there is a signal $V_p(s)$ which reaches a control input of the modulator PM. The signal $V_p(s)$ controls the phase variation added to the phase of the oscillation which reaches the signal input of the modulator PM.

At the output of the phase modulator PM there is a signal $\Theta_o(s)$ which represents the oscillation phase output from the phase modulator PM.

The signal $V_i(s)$ is the input signal of the circuit derived from the block diagram of FIG. 1, and if said circuit were used in a phase-locked loop (PLL), it would represent the phase error signal; otherwise $V_i(s)$ is a generic signal which controls the frequency variations of the VCXO.

Analysis of the operation is carried out in the domain of the Laplace transform, therefore all the signals are functions of the variable $\underline{s}$, where $\underline{s}$ is assumed equal to $j\omega$ if it is desired to consider the sinusoidal state. The individual blocks can be diagramed by means of their transfer functions.

The analysis makes use of linear approximation, which is applicable if the frequency variations of the signal output from the modulator PM, caused overall by the input signal $V_i$, are small in relation to the nominal frequency of the VCXO.

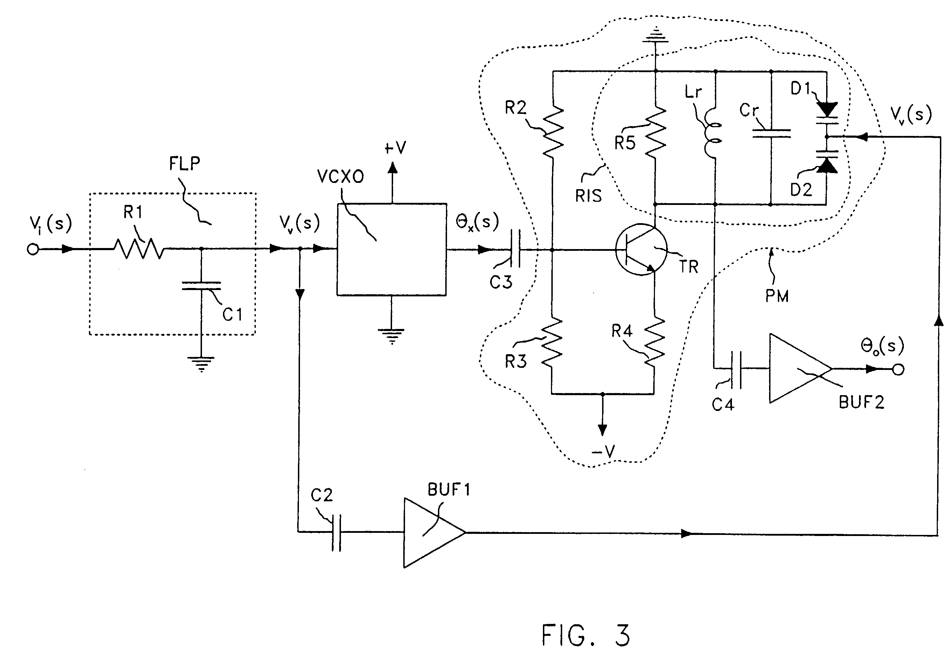

In the circuit of FIG. 3 the above conditions are respected. Indeed, the VCXO has a nominal frequency of 19,440kHz which is much more than that of the maximum frequency variation of the signal output from the modulator PM which is on the order of 50kHz.

For purposes of analysis no limit is placed on the band width of the input signal $V_i(s)$ which controls the VCXO. Therefore the highest frequency fcmax contained in the band of $V_i(s)$ can exceed the critical value fcr, so that the behaviour of the VCXO is no longer ideal. The block diagram of FIG. 1 shows how to remedy the limitation in the frequency response band of the VCXO because of the non-ideal quality thereof, occurring just when $f_{cmax} > $ fcr.

As a result of the foregoing as will be clarified below, to simplify the analysis it is possible to characterize the block VCXO with a transfer function corresponding to that of an ideal VCXO without introducing appreciable errors.

Being $F_{xo}(s)$ the transfer function of the block VCXO, as regards only the phase $\Theta_x(s)$, it is thus:

$$F_{xo}(s) = \Theta_x(s)/V_v(s) = K_{vcxo}/s$$

the magnitude $K_{vcxo}$ expressed in radiants/(voltxsecond) characterizing the frequency gain of the VCXO had already been defined.

The transfer function of the low-pass filter FLP is $F_1(s) = V_v(s)/V_i(s) = 1/(1 + s\tau_1)$, $\tau_1$ being the time constant of the filter FLP.

The transfer function of the filtering network FLA is $F_2(s) = V_p(s)/V_i(s)$ whose expression will be defined below.

Being $F_{pm}(s)$ the transfer function of the phase modulator PM, as regards the phase $\Theta_o(s)$ of the output signal, is:

$$F_{pm}(s) = \Theta_x(s) + K_{pm}V_p(s)$$

$K_{pm}$ being a magnitude expressed in radiant/volt which characterizes the phase gain of the modulator.

Knowing the transfer functions of the individual blocks, it is now possible to establish the overall transfer function of the circuit represented by the block diagram of FIG. 1. Calling the above function $F_3(s)$, we have:

$$\Theta_o(s) = F_3(s)V_i(s)$$

from which: $\Theta_o(s) = \Theta_x(s) + K_{pm}V_p(s) =$
$= F_{xo}(s)V_v(s) + K_{pm}V_p(s) =$
$= F_{xo}(s)F_1(s)V_i(s) + K_{pm}F_2(s)V_i(s) =$
$= [F_{xo}(s)F_1(s) + K_{pm}F_2(s)]V_i(s) =$
$= [(K_{vcxo}/s)(1/(1 + s\tau_1)) + K_{pm}F_2(s)]V_i(s)$
therefore $F_3(s) = [(K_{vcxo}/(s(1 + s\tau_1) + K_{pm}F_2(s)]$

The block diagram of FIG. 1 has the purpose of broadening the frequency response of a voltage controlled crystal oscillator which is also included in the block diagram like block VCXO. It follows that the entire block diagram can be assimilated to a voltage controlled crystal oscillator having a frequency response band broader than that of the starting oscillator. Within this widened band the new controlled oscillator represented by the block diagram behaves like an ideal oscillator.

Consequently the transfer function $F_3(s)$ of the overall block diagram of FIG. 1 as regards the output signal phase must coincide with $K_{vcxo}/s$ which corresponds to the transfer function of an ideal VCXO. I.e. the following relationship must apply:

$$F_3(s) = K_{vcxo}/s$$

from which, after the necessary elaboration, the following final expression is reached:

$$K_{vcxo}\tau_1/(1 + s\tau_1) = K_{pm}F_2(s)$$

which is equivalent to the following two relations:

$$K_{vcxo}\tau_1 = K_{pm}$$

$$1/(1 + s\tau_1) = F_2(s) = F_1(s)$$

the first of which supplies the criterion of how to dimension the filter FLP and the gains of VCXO and PM. The second relation shows clearly how the filtering network FLA is superfluous because: $V_p = F_2(s)V_i(s) = F_1(s)V_i(s) = V_v(s)$, therefore the signal $V_v(s)$ can be applied to the control inputs both of the VCXO and the modulator PM. The circuitry configuration derived therefrom is represented by the block diagram of FIG. 2.

With reference to FIG. 2, in which the elements common with FIG. 1 are indicated by the same symbols, we note that it differs from FIG. 1 only in that the filtering network FLA is absent, and the signal $V_v(s)$ is applied directly also to the control input of the modulator PM.

Calling F4(s) the transfer function of the circuit represented by the block diagram of FIG. 2 it is taken directly from $F_3(s)$ substituting for $K_{pm}$ and $F_2(s)$ the respective expressions previously found. Recalling also that $\tau_1 = 1/\omega_1 = 1/2\pi f_1$ where $f_1$ is the cutoff frequency of the filter FLP we find:

$$F_4(s) = [K_{vcxo}/s + K_{vcxo}/\omega_1]1/(1 + s/\omega_1) = K_{vcxo}/s$$

where the first of the two addends in square brackets is the contribution of the block VCXO to the signal $\Theta_o$, while the second addend is the contribution to $\Theta_o$ of the phase modulator PM.

Assuming $\underline{s} = j\omega$ it is possible to evaluate the trend in frequency of $|F_4(j\omega)|$. It is noted immediately that the first addend decreases hyperbolically with the frequency while the second addend is constant. At the frequencies for which $\omega < \omega_1$ the contribution of VCXO prevails and consequently $\Theta_o$ is approximately equal to $\Theta_x$. At the frequencies for which $\omega = \omega_1$ the two addends are equal and the contributions to $\Theta_o$ are determined in equal parts by VCXO and PM. At the frequencies for which $\omega > \omega_1$ the contribution of the phase modulator PM prevails because the value of the first addend becomes quickly insignificant at frequencies slightly greater than $\omega_1/2\pi$. Both of said contributions are also multiplied by the term $1/(1 + s/\omega_1)$ which does not appreciably reduce the contribution of the VCXO, becoming sensitive on the contribution of PM only at the frequencies for which $\omega > \omega_1$.

The analysis started from the assumption that the block VCXO had a phase/voltage transfer function corresponding to that of an ideal VCXO. For said assumption to be valid it is essential that the cutoff frequency f1 of the filter FLP be less than the critical frequency fcr of the VCXO. If this is verified the result is that at the frequencies for which the behaviour of the VCXO moves away from the ideal, the input signal $V_i(j\omega)$ is attenuated in such a manner as to not cause significant variations in the phase $\Theta_x$. The phase modulator PM compensates for the loss of modulation of the phase $\Theta_x$ occurring starting from the frequencies greater than $f_1$.

With reference to FIG. 3 in which the elements common to FIG. 2 are indicated by the same symbols, we note the low-pass filter FLP whose input is reached by the signal $V_i$. Said filter comprises a resistor R1 and a capacitor C1 connected as in the characteristic configuration of a low-pass filter of the first order. The output of the filter is connected to the control input of the voltage-controlled crystal oscillator VCXO and to the input of an amplifier BUF1 through a capacitor C2 of great capacity.

The oscillator VCXO has a Colpitts configuration and its oscillation frequency is controlled in a known manner. The crystal used has a characteristic resonance frequency of 19,440kHz. The output of VCXO is connected to the base of an n-p-n bipolar transistor TR by means of a capacitor C3. To the base of TR are connected the ends of two resistors R2 and R3 whose other ends are connected to the ground connection and the negative battery terminal respectively and to the latter is also connected the emitter of TR by means of a resistor R4.

The collector of TR is connected to one end of a resonant circuit RIS consisting of the parallel of a resistor R5, an inductor Lr, a capacitor Cr, and a pair of varicap diodes D1 and D2 having the same physical characteristics and connected together in series with the anodes opposed and cathodes in common. The other end of the resonant circuit RIS is connected to the ground connection.

The phase modulator PM consists of the transistor TR, the resonant circuit RIS and the resistors R2, R3, R4 which serve for the correct polarization of TR.

The output of the amplifier BUF1 is connected to the cathodes of the varicap diodes D1 and D2. Said amplifier supplies to the control signal $V_v$ present at the output of FLP the appropriate polarity and level for correct piloting of the varicap diodes.

The collector TR is also connected through a capacitor C4 of small capacity to the input of an amplifier BUF2 whose output is connected to the output terminal of the circuit which is the object of the present invention. The amplifier BUF2 receives the modulated signal present on the collector of TR and give it the necessary output power.

Operation of the circuit of FIG. 3 is drawn from that previously illustrated for the block diagram of FIG. 2 from which the circuit is derived. Therefore the transfer function of the circuit shown in the figure coincides with the expression $F_4(s)$ in which are assigned the values of $K_{vcxo}$ and $\omega_1$ compatibly with the external constraints of the design.

The circuit of the nonlimiting example of FIG. 3 is inserted in a phase-locked loop, not visible in the figure, to whose input arrives a digital signal having great frequency stability. The highest frequency variation tolerated for said signal is uniformly lower than 1kHz.

The VCXO used has a frequency gain $K_{vcxo}$ of 1260 radiants/(voltxsecond), corresponding to approximately 200Hz/V. With this value of $K_{vcxo}$ the greatest possible swing of the control voltage $V_v$ causes a variation of the frequency of the VCXO on the order of ± 1kHz which is more than sufficient to allow the PLL to phase lock the input signal, allowing also for any further variations in the frequency of the VCXO caused overall by ageing phenomena and thermal drifts.

Such a small value of the range of variation of the frequency of the VCXO, in any case sufficient for the requirement, is justified by the fact that the frequency stability of a VCXO is as much greater, as much lower is its possible range of frequency swing.

The values of R1 and C1 are chosen in such a manner that $f_1$ = 2.5kHz, a value which is surely lower than the critical frequency $f_{cr}$ of the VCXO used. With the above values there is obtained: $K_{pm}$ = $K_{vcxo}/\omega_1$ = $1260/2\pi \times 2,5 \times 10^3$ = $8 \times 10^{-2}$ radiants/V, which corresponds to 4.6 degrees/volt.

The transistor TR is an amplifier in the common collector configuration which transfers to the ends of the resonant circuit RIS the signal which reaches it from VCXO without introducing its own significant contribution to the phase of the transiting signal. In practice it behaves like a buffer placed between VCXO and RIS.

The values of $L_r$, $C_r$ and the nominal capacity of the varicap diodes are such that nominal resonance frequency of the resonant circuit RIS has a value of 19,440kHz, which coincides with the value of $f_x$. A variation of level of the control voltage $V_v$ causes a variation in the capacity of the varicap diodes D1 and D2 in increase or decrease in relation to the nominal capacity value. This brings a variation in the overall capacity of the circuit RIS and consequently a variation in the resonance frequency and hence of the phase $\Theta_o$.

The value of R2 is such that the Q-factor of the resonant circuit RIS is low. This allows full utilization of the dynamic of the swing levels of the voltage Vv without leaving the linearity range $K_{pm}$. It is also known that a low Q-factor minimizes the effects of temperature changes on the resonance frequency of the circuit.

## Claims

1. Process for broadening the frequency response band of a voltage-controlled crystal oscillator characterized in that:

     a control signal ($V_i$) is passed through a low-pass filter obtaining a filtered control signal ($V_v$) applied to the control input of said oscillator (VCXO),
     in that to the phase ($\Theta_x(s)$) of the signal generated by said oscillator (VCXO) is added algebraically, instant by instant, a further phase contribution proportional to the level of said filtered control signal ($V_v$) in accordance with a proportionality constant ($K_{pm}$), and
     and in that the passing band ($f_1$) of said low-pass filter (FLP) is less than the frequency response band ($f_{cr}$) of said oscillator (VCXO), said further phase contribution being significant at the frequencies higher than the cut-off frequency of said low-pass filter.

2. Process for broadening the frequency response band of a voltage-controlled crystal oscillator in accordance with claim 1, characterized in that said low-pass filter (FLP) is of the first order, and in that said proportionality constant ($K_{pm}$) is equal to the product of the frequency gain ($K_{vcxo}$) of said oscillator (VCXO) multiplied by the time constant ($\tau_1$) of said low-pass filter (FLP).

3. Circuit for broadening the frequency response band of a voltage-controlled crystal oscillator, characterized in that it comprises:

     a low-pass filter (FLP) to whose input arrives a control signal ($V_i$) and at whose output there is a filtered control signal ($V_v$) applied at the control input of said voltage-controlled crystal oscillator (VCXO), in which the passing band ($f_1$) of said filter (FLP) is less than the frequency response band ($f_{cr}$) of said oscillator (VCXO), and
     a phase modulator (PM) having a signal input to which arrives the signal generated by said controlled oscillator (VCXO) and a modulation input to which arrives said filtered control signal ($V_v$), in which, instant by instant, to the phase ($\Theta_x(s)$) of the signal generated by said oscillator (VCXO) is added a further phase contribution proportional to the level of said filtered control signal ($V_v$) in accordance with a proportionality constant ($K_{pm}$), said further phase contribution being significant at the frequencies higher than the cut-off frequency of said low-pass filter.

4. Circuit for broadening the frequency response band of a voltage-controlled crystal oscillator in accordance with claim 3, characterized in that said low-pass filter (FLP) is of the first order and said proportionality constant ($K_{pm}$) is equal to the product of the frequency gain ($K_{vcxo}$) of said oscillator (VCXO) multiplied by the time constant ($\tau 1$) of said low-pass filter (FLP).

## Patentansprüche

1. Verfahren zur Erweiterung der Durchlaßfrequenzbandbreite eines spannungsgesteuerten Kristalloszillators, **dadurch gekennzeichnet,**

     daß ein Steuersignal ($V_i$) ein Tiefpaßfilter durchläuft, wodurch ein gefiltertes Steuersignal ($V_v$) entsteht, das an den Steuereingang des genannten Oszillators (VCXO) angelegt wird,
     daß zu der Phase ($\theta_x(s)$) des von dem genannten Oszillator (VCXO) erzeugten Signals ein weiterer, dem Pegel des genannten gefilterten Steuersignals ($V_v$) proportionaler Phasenbei-

trag Augenblick für Augenblick nach Maßgabe einer Proportionalitätskonstanten ($K_{pm}$), algebraisch addiert wird, und
daß das Durchlaßband ($f_1$) des genannten Tiefpaßfilters (FLP) schmaler ist als die Durchlaßfrequenzbandbreite ($f_{cr}$) des genannten Oszillators (VCXO), wobei der genannte weitere Phasenbeitrag bei Frequenzen Bedeutung gewinnt, die höher liegen als die Grenzfrequenz des genannten Tiefpaßfilters.

2. Verfahren zur Erweiterung der Durchlaßfrequenzbandbreite eines spannungsgesteuerten Kristalloszillators nach Anspruch 1, **dadurch gekennzeichnet,** daß das genannte Tiefpaßfilter (FLP) erster Ordnung ist, und daß die genannte Proportionalitätskonstante ($K_{pm}$) gleich dem Produkt aus der Frequenzverstärkung ($K_{vcxo}$) des genannten Oszillators (VCXO) und der Zeitkonstanten ($\tau_1$) des genannten Tiefpaßfilters (FLP) ist.

3. Schaltkreis zur Erweiterung der Durchlaßfrequenzbandbreite eines spannungsgesteuerten Kristalloszillators, **dadurch gekennzeichnet,** daß dieser folgendes enthält:

ein Tiefpaßfilter (FLP), an dessen Eingang das Steuersignal ($V_i$) ansteht und an dessen Ausgang das gefilterte Steuersignal ($V_v$) erscheint, das an den Steuereingang des genannten spannungsgesteuerten Kristalloszillators (VCXO) angelegt wird, wobei das Durchlaßband ($f_1$) des genannten Filters (FLP) schmaler ist als die Durchlaßfrequenzbandbreite ($f_{cr}$) des genannten Oszillators (VCXO), und
einen Phasenmodulator (PM) mit einem Signaleingang, an dem das von dem genannten gesteuerten Oszillator (VCXO) erzeugte Signal ansteht, und einem Modulationseingang, an dem das genannte gefilterte Steuersignal (Vv) ansteht, in welchem zu der Phase ($\theta_x(s)$) des von dem genannten Oszillator (VCXO) erzeugten Signals Augenblick für Augenblick nach Maßgabe einer Proportionalitätskonstanten ($K_{pm}$) ein weiterer, dem Pegel des genannten gefilterten Steuersignals ($V_v$) proportionaler Phasenbeitrag algebraisch addiert wird, wobei der genannte weitere Phasenbeitrag bei Frequenzen Bedeutung gewinnt, die höher als die Grenzfrequenz des genannten Tiefpaßfilters liegen.

4. Schaltkreis zur Erweiterung der Durchlaßfrequenzbandbreite eines spannungsgesteuerten Kristalloszillators nach Anspruch 3, **dadurch gekennzeichnet,**
daß das genannte Tiefpaßfilter (FLP) erster Ordnung ist und die genannte Proportionalitätskonstante ($K_{pm}$) gleich dem Produkt aus der Frequenzverstärkung ($K_{vcxo}$) des genannten Oszillators (VCXO) und der Zeitkonstanten ($\tau_1$) des genannten Tiefpaßfilters (FLP) ist.

**Revendications**

1. Procédé pour étendre la bande de réponse en fréquence d'un oscillateur à cristal contrôlé par une tension, caractérisé en ce que :

un signal de contrôle ($V_i$) passe à travers un filtre passe-bas pour obtenir un signal de contrôle filtré ($V_v$) qui est appliqué à l'entrée de contrôle du dit oscillateur (VCXO),
en ce qu'à la phase ($\theta(s)$) du signal généré par ledit oscillateur (VCXO) est additionné algébriquement, instant après instant, une contribution de phase supplémentaire proportionnelle au niveau du dit signal de contrôle filtré ($V_v$) en accord avec la constante de proportionnalité ($K_{pm}$), et
et en ce que la bande passante ($f_1$) du dit filtre passe-bas (FLP) est inférieure à la bande de réponse en fréquence ($f_{cr}$) du dit oscillateur (VCXO), ladite contribution de phase supplémentaire étant significative à des fréquences supérieures à la fréquence de coupure du dit filtre passe-bas.

2. Procédé pour étendre la bande de réponse en fréquence d'un oscillateur à cristal contrôlé par une tension, suivant la revendication 1, caractérisé en ce que ledit filtre passe-bas (FLP) est du premier ordre, et en ce que ladite constante de proportionnalité ($K_{pm}$) est égale au produit du gain en fréquence ($K_{vcxo}$) du dit oscillateur (VCXO) multiplié par la constante de temps ($\tau_1$) du dit filtre passe-bas (FLP).

3. Circuit pour étendre la bande de réponse en fréquence d'un oscillateur à cristal contrôlé par une tension, caractérisé en ce qu'il comprend :

un filtre passe-bas (FLP) à l'entrée duquel arrive un signal de contrôle ($V_i$) et à la sortie duquel se trouve un signal de contrôle filtré ($V_v$) appliqué à l'entrée de contrôle du dit oscillateur à cristal contrôlé par une tension (VCXO), la bande passante ($f_1$) du dit filtre (FLP) étant inférieure à la bande de réponse en fréquence ($f_{cr}$) du dit oscillateur (VCXO), et
un modulateur de phase (PM) ayant une entrée de signal sur laquelle arrive le signal généré par ledit oscillateur contrôlé (VCXO) et une entrée de modulation sur laquelle arrive ledit signal de

contrôle filtré ($V_v$), dans lequel, instant après instant, la phase ($\theta_x(s)$) du signal généré par ledit oscillateur (VCXO) est additionnée à une contribution de phase supplémentaire proportionnelle au niveau du dit signal de contrôle filtré ($V_v$) selon une constante de proportionnalité ($K_{pm}$), ladite contribution de phase supplémentaire étant significative aux fréquences supérieures à la fréquence de coupure du dit filtre passe-bas.

4. Circuit pour étendre la bande de réponse en fréquence d'un oscillateur à cristal contrôlé par une tension suivant la revendication 3, caractérisé en ce que ledit filtre passe-bas (FLP) est du premier ordre, et en ce que ladite constante de proportionnalité ($K_{pm}$) est égale au produit du gain en fréquence ($K_{vcxo}$) du dit oscillateur (VCXO) multiplié par la constante de temps ($\tau_1$) du dit filtre passe-bas (FLP).

FIG. 1

FIG. 2

FIG. 3